(19) Europäisches Patentamt
European Patent Office
Office européen des brevets

(11) **EP 3 128 533 A1**

(12) **EUROPEAN PATENT APPLICATION**
published in accordance with Art. 153(4) EPC

(43) Date of publication:
**08.02.2017 Bulletin 2017/06**

(51) Int Cl.:
**H01L 21/02** $^{(2006.01)}$ **H01L 21/3065** $^{(2006.01)}$
**H05B 3/68** $^{(2006.01)}$

(21) Application number: **14887811.9**

(22) Date of filing: **31.03.2014**

(86) International application number:
**PCT/JP2014/059435**

(87) International publication number:
**WO 2015/151151 (08.10.2015 Gazette 2015/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: SPP Technologies Co., Ltd.
**Tokyo 100-0004 (JP)**

(72) Inventors:
• HAYAMI, Toshihiro
**Amagasaki-shi**
**Hyogo 660-0891 (JP)**

• FUJII, Ryosuke
**Amagasaki-shi**
**Hyogo 660-0891 (JP)**

(74) Representative: **Isarpatent**
**Patent- und Rechtsanwälte Behnisch Barth Charles**
**Hassa Peckmann & Partner mbB**
**Friedrichstrasse 31**
**80801 München (DE)**

(54) **HEATING DEVICE AND PLASMA TREATMENT DEVICE PROVIDED WITH SAME**

(57)     A heating device capable of efficiently heating an object to be heated with a small heating element and a plasma processing apparatus provided with the heating device are provided. A plasma processing apparatus 1 includes a processing chamber 2 having a plasma generating space 3a defined in an upper portion thereof and a processing space 4a defined in a lower portion thereof, a platen 9 disposed in the processing space 4a for placing a substrate K thereon, a processing gas supply unit 7 supplying a processing gas into the plasma generating space 3a, a plasma generating unit 5 generating plasma from the processing gas supplied into the plasma generating space 3a by RF power, a plasma-generation RF power supply 6 supplying RF power to the plasma generating unit 5, and a heating device 13. The heating device 13 is composed of a heating element 14 including a conductor having a product $\rho \cdot \mu$ [$\Omega \cdot$H] of its electrical resistivity $\rho$ [$\Omega \cdot$m] and its magnetic permeability $\mu$ [H/m] equal to or greater than $8.0 \times 10^{-13}$, and a heating RF power supply 16 supplying RF power to the heating element 14.

*F I G. 1*

## Description

### Technical Field

0001 The present invention relates to a heating device capable of efficiently heating an object to be heated with a small heating element, and to a plasma processing apparatus provided with the heating device.

### Background Art

0002 The plasma processing apparatus as mentioned above typically includes a processing chamber having a plasma generating space defined in an upper portion thereof and a processing space defined below the plasma generating space, a platen disposed in the processing space for placing an object to be processed thereon, a processing gas supply unit supplying a processing gas into the plasma generating space, a plasma generating unit generating plasma from the processing gas supplied into the plasma generating space by RF power, and a plasma-generation RF power supply supplying RF power to the plasma generating unit.

0003 In such a plasma processing apparatus, the plasma generating unit generates plasma from a processing gas supplied into the plasma generating space, and a substrate placed on the platen in the processing space is processed by the plasma generated from the processing gas.

0004 In this process, the substrate is preheated before start of the plasma processing to raise the temperature thereof to an equilibrium temperature to be reached in the processing so as to start a stable processing immediately after start of the plasma processing, and a heating device disclosed in Patent Literature 1 mentioned below has been known as a heating device for heating a substrate.

0005 This heating device is composed of a heater embedded in the platen and a heater power supply supplying electric power to the heater. The heater is composed of a filament made of carbon or the like and an insulator, such as ceramics, surrounding the filament, and Joule heat is generated for heating by causing a current to flow from the heater power supply to the heater. A commercial alternating-current power supply having a frequency of 50 Hz or 60 Hz (AC 100 V or 200 V) or a direct-current power supply is conventionally used as the heater power supply for generating Joule heat.

### Citation List

### Patent Literature

0006 *Patent document 1:* Japanese Unexamined Patent Application Publication No. H10-303185

### Summary of Invention

### Technical Problem

0007 By the way, in recent years, a plasma processing apparatus intended for production of many models in small quantities, which processes a substrate having a diameter equal to or smaller than 1 inch, has been developed instead of a plasma processing apparatus intended for mass production, which processes a substrate having a diameter between 6 inches and 12 inches. In such a plasma processing apparatus, the processing chamber necessarily has a small size and a small-sized platen suffices for placing the substrate thereon.

0008 However, in a heating device which uses a commercial alternating-current power supply or a direct-current power supply as a heater power supply and uses a filament as a heater as in the conventional art, in order to obtain an amount of heat generation necessary for heating a substrate to a desired temperature, it is necessary for the filament to have a length corresponding to its specific electrical resistance (electrical resistivity) [Ω·m]. Therefore, application of such a heating device to a small-sized platen is naturally limited. That is, such a heating device has a problem that it cannot deal with miniaturization of apparatus because the size of the heater will exceed the size of the platen.

0009 The present invention has been achieved in view of the above-described circumstances and an object thereof is to provide a heating device capable of efficiently heating an object to be heated with a small heating element and a plasma processing apparatus provided with the heating device.

### Solution to Problem

0010 The present invention, for solving the above-described problem, relates to a heating device including a heating element and a heating RF power supply supplying RF power to the heating element, the heating element including a conductor having a product $\rho \cdot \mu$ [Ω·H] of its electrical resistivity $\rho$ [Ω·m] and its magnetic permeability $\mu$ [H/m] equal to or greater than $8.0 \times 10^{-13}$.

0011 When RF power is applied to a conductor, a phenomenon called "skin effect" occurs in which a current flows only in a skin layer of the conductor having a certain depth from the conductor surface. A resistance value $R_1$ [Ω] of the conductor in such a case is represented by the following equation:

$$\text{(Equation 1)}$$
$$R_1 = (\rho / d) \cdot (L / (\pi \cdot (D - d))),$$

where D [m] is the diameter of the conductor, L [m] is the length of the conductor, d [m] is the skin depth, and $\rho$

[Ω·m] is the electrical resistivity of the conductor. Further, assuming the diameter D [m] to be sufficiently larger than the skin depth d [m], that is, D ≥ d, the resistance value $R_1$ [Ω] can be approximated by the following equation:

(Equation 2)

$$R_1 \approx (\rho / d) \cdot (L / (\pi \cdot D))$$

0012 Further, using the magnetic permeability of the conductor represented by $\mu$ [H/m] allows the skin depth d [m] to be presented by the following equation:

(Equation 3)

$$d = (2\rho / \omega \cdot \mu))^{1/2},$$

where w is an angular frequency [rad/s].

Further, since the angular frequency [rad/s] is equal to $2\pi f$ (f is a frequency [Hz]), the skin depth d [m] can be represented by the following equation:

(Equation 4)

$$d = (\rho / \pi \cdot f \cdot \mu))^{1/2}.$$

Therefore, the resistance value $R_1$ [Ω] can be represented by the following equation:

(Equation 5)

$$R_1 = ((f \cdot \rho \cdot \mu) / \pi)^{1/2} \cdot (L / D))$$

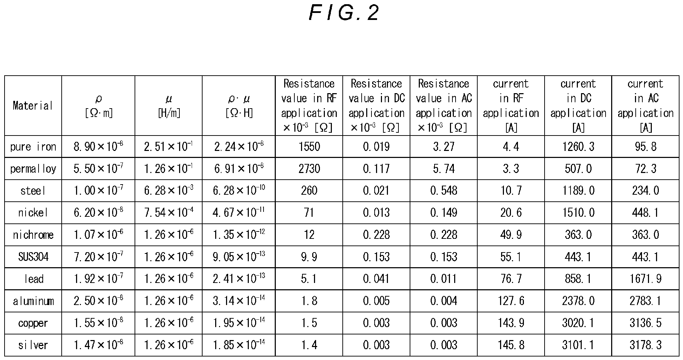

0013 For each of various conductors: pure iron, permalloy (45Ni-Fe), steel, nickel, nichrome, SUS304, lead, aluminum, copper, and silver, the resistance value [Ω] and a flowing current [A] when the conductor was used as a heating element were calculated for a) a case of application of RF power of 13.56 [MHz], b) a case of application of a direct-current power, and c) a case of a commercial alternating-current power (60Hz) (hereinafter, simply referred to as "alternating-current power"); in the calculation, the length L and the diameter D [m] of the conductor were 0.15 [m] and 0.03 [m], respectively, and the power to be applied was 30 [W]. Results of the calculation are shown in Fig. 2.

0014 Note that the resistance value $R_1$ [Ω] in the case of RF power application was calculated in accordance with Equation 5 given above.

Further, the resistance value $R_2$ [Ω] in the case of direct-current power application was calculated in accordance with the following equation:

(Equation 6)

$$R_2 = (4\rho \cdot L) / (\pi \cdot D^2).$$

Furthermore, the resistance value $R_3$ [Ω] in the case of alternating-current power application was calculated in accordance with Equation 7 given below (which is the same as Equation 5 given above) or Equation 8 given below (which is the same as Equation 6 given above) depending on the conductor; Equation 7 was used in the case where the skin depth in the skin effect was less than the radius of the conductor, and Equation 8 was used in the case where the skin depth was equal to or greater than the radius of the conductor.

(Equation 7)

$$R_3 = ((f \cdot \rho \cdot \mu) / \pi)^{1/2} \cdot (L / D))$$

(Equation 8)

$$R_3 = (4\rho \cdot L) / (\pi \cdot D^2)$$

0015 As shown in Fig. 2, as for all of the conductors, the resistance value [Ω] is greatly larger in the case of RF power application than in the cases of direct-current power application and alternating-current power application, and the workload of 30 [W] can be obtained with a smaller current in the case of RF power application than in the cases of direct-current power application and alternating-current power application. Meanwhile, as for conductors showing a product $\rho \cdot \mu$ [Ω·H] of the electrical resistivity $\rho$ [Ω·m] and the magnetic permeability $\mu$ [H/m] equal to or greater than $8.0 \times 10^{-13}$ (pure iron, permalloy, steel, nickel, nichrome, and SUS304), their resistance values [Ω] in the case of RF power application are considerably greater than those of the other conductors (lead, aluminum, copper, and silver), and the workload of 30 [W] can be obtained with a smaller current as compared with the other conductors.

0016 For example, a comparison is made between SUS304 and aluminum. In the case of RF power application, the resistance value of SUS304 is 9.9 (about 10) [Ω], while the resistance value of aluminum is 1.8 [Ω], which is about one fifth of that of SUS304. Further, the current necessary for obtaining the workload of 30 [W] is 55.1 [A] in the case of SUS304, while it is 127.6 [A] in the case of aluminum, which is about 2.3 times that of SUS304. Note that, although nichrome has been widely used as a heating element, the resistance value SUS304 shows in the case where SUS304 is used as a heating element and RF power is used as a heating power supply (9.9 [Ω]) was about 43 times the resistance value nichrome shows in the case where direct-current power or an alternating-current power is used as in the conventional art (0.228 [Ω]). Therefore, according to the present invention, it is possible to obtain a resistance value much greater than that obtained with the conventional heating mechanism, and it is possible to obtain a necessary Joule heat with a smaller current (the RF current necessary for obtaining the workload of 30 [W] with the use of SUS304 is 55.1 [A], while the direct current or alternating current necessary for obtaining the workload of 30 [W] with the use of nichrome was 443.1 [A], which was about eight times said RF current).

0017 Thus, in the case where RF power is used as a heating power supply, the size of the heating element can be reduced since the heating element shows a great resistance value [Ω]. On the other hand, in the case where direct-current power or alternating-current power is used as a heating power supply, it is necessary to increase the resistance value [Ω] in order to reduce the flowing current, and it is necessary to increase the length of the heating element, that is, it is necessary to increase the size of the heating element, in order to increase the resistance value [Ω]. Further, in the case where RF power is used, a heating element including a conductor having the $\rho \cdot \mu$ [Ω·H] equal to or greater than $8.0 \times 10^{-13}$ shows a greater resistance value than those including other conductors; therefore, such a conductor can be reduced in size.

0018 Further, in the case where RF power is used as a heating power supply, a smaller current suffices for obtaining the same workload, that is, the same Joule heat, as compared with direct-current power and alternating-current power. Further, the same Joule heat can be obtained with an even smaller current by using a heating element including a conductor showing the $\rho \cdot \mu$ [Ω·H] equal to or greater than $8.0 \times 10^{-13}$.

0019 As described above, direct-current power and alternating-current power are not suitable for a power supply for heating such a platen as is used in a plasma processing apparatus processing a substrate having a diameter equal to or smaller than 1 inch, which platen is reduced in size corresponding to the substrate, whereas RF power is suitable therefor. Further, a heating element including a conductor having the $\rho \cdot \mu$ [Ω·H] equal to or greater than $8.0 \times 10^{-13}$ is preferred in that it enables setting a great resistance value and obtaining the same Joule with a smaller current.

0020 Thus, according to the heating device of the present invention, it is possible to efficiently heat an object to be heated with a small heating element.

0021 Note that examples of the conductor having the $\rho \cdot \mu$ [Ω·H] equal to or greater than $8.0 \times 10^{-13}$ include ferromagnetic substances such as iron, cobalt, nickel, gadolinium, stainless steel, Fe-Co, Fe-Ni, Fe-Co-Ni, Co-Ni, Fe-Si, Fe-Mn-Zn, Fe-Ni-Zn, Fe-Co-Ni-Cr, Fe-Co-Ni-P, Fe-Co-B, Fe-Co-Cr-B, and Fe-Co-V, nichrome, and alloys made of one or more of the foregoing substances and lanthanide. Further, besides heating elements made of these conductors, a heating element made by coating an appropriate base material with any one of these conductors may be used as the heating element. In the case of this coating mode, it is preferred that the thickness of the coating is equal to or greater than a skin thickness in the skin effect which develops in the case where an RF power having an appropriate frequency is applied.

0022 Further, in the present invention, it is more preferred that the heating element includes a conductor having the $\rho \cdot \mu$ [Ω·H] equal to or greater than $4.0 \times 10^{-11}$, because it shows a greater resistance value [Ω].

0023 Further, it is preferred that the frequency of the RF power is equal to or greater than 100 kHz. As understood from Equation 5 given above, the resistance value [Ω] of the heating element is proportional to its length and the frequency of the RF power. Therefore, setting the frequency of the RF power to be equal to or greater than 100 kHz allows the length of the heating element to be set at such a length that the heating device can deal with miniaturization. Not that, in terms of dealing with miniaturization, the frequency is more preferred to be equal to or greater than 300 kHz, and even more preferred to be equal to or greater than 10 MHz.

0024 Further, it is preferred that the heating device further includes a current adjusting unit adjusting a current supplied to the heating element from the heating RF power supply. An amount of heat generation of the heating element, that is, a heating temperature of the heating element can be adjusted to an appropriate temperature by adjusting the current supplied to the heating element with the current adjusting unit.

0025 The present invention also relates to a plasma processing apparatus including a processing chamber having a processing portion therein, a platen disposed in the processing potion for placing an object to be processed thereon, a processing gas supply unit supplying a processing gas into the processing portion, a plasma generating unit generating plasma from the processing gas supplied into the processing portion by RF power, and a plasma-generation RF power supply supplying RF power to the plasma generating unit, the plasma processing apparatus further including the above-described heating device, the heating element being attached to or embedded in the platen in a state of being covered with or embedded in an insulator.

0026 As described above, the heating device is capable of efficiently heating an object to be heated with a small heating element. Therefore, even when the plasma processing apparatus using the heating device is a small-sized apparatus processing a substrate having a diameter equal to or smaller than 1 inch and the platen for placing the substrate thereon is also small in size, the heating element can be attached to or embedded in the platen in a state of being covered with or embedded in an insulator. Further, using this heating device makes it possible to heat a substrate on the platen to a target temperature in a short time.

0027 Further, in the present invention, it is preferred that the heating RF power supply is connected to the platen and the heating element so as to supply RF power to the platen and the heating element. In a plasma processing apparatus, usually, a bias potential is applied to the platen by applying RF power to the platen and a substrate is processed while the bias potential is being applied to the platen. Therefore, a configuration in which RF power is supplied to the platen and the heating element from the same RF power which is shared by them leads to reduction of RF power supply, and therefore cost for the plasma processing apparatus can be reduced.

0028 Further, in the present invention, it is preferred that the heating RF power supply is connected to the platen and the heating element via a connection switching unit and is configured to be alternatively connected to the platen or the heating element by a switching operation in the connection switching unit so as to alternatively supply RF power to the platen or the heating element. As described above, in a plasma processing apparatus, the heating device is used mainly for preheating a substrate before start of processing so as to start a stable processing immediately after start of processing. Therefore, it is sufficient for the heating device to be supplied with RF power at the time of preheating before start of processing. On the other hand, it is sufficient for the platen to be supplied with RF power during processing in order to apply a bias potential thereto. Accordingly, when the heating RF power supply is configured as described above, it is possible to supply RF power to the heating element at the time of preheating before start of processing and to the platen during processing. Further, such a configuration prevents excessive power consumption, and therefore is preferable in terms of energy efficiency.

Advantageous Effects of Invention

0029 According to the heating device of the present invention, it is possible to efficiently heat an object to be heated with a small heating element. Further, the heating device is preferably applicable to a small-sized plasma processing apparatus processing a substrate having a diameter equal to or smaller than 1 inch, and even when the platen for placing the substrate thereon is small in size, the heating element can be attached to or embedded in the platen in a state of being covered with or embedded in an insulator. Further, using this heating device makes it possible to heat a substrate on the platen to a target temperature in a short time. Furthermore, in the case where this heating device is used in a plasma processing apparatus, if it is necessary to supply RF power to the platen to apply a bias potential thereto, the RF power supply for supplying RF power to the heating element may be used also for supplying RF power to the platen. This configuration leads to reduction of power supply, and therefore cost for the plasma processing apparatus can be reduced. Brief Description of Drawings

0030

Fig. 1 is an illustration showing a schematic configuration of a plasma processing apparatus according to an embodiment of the present invention;
Fig. 2 is an illustration for explaining effects of the present invention;
Fig. 3 is an illustration showing a schematic configuration of a plasma processing apparatus according to another embodiment of the present invention; and
Fig. 4 is an illustration showing a schematic configuration of a plasma processing apparatus according to yet another embodiment of the present invention.
Description of Embodiments

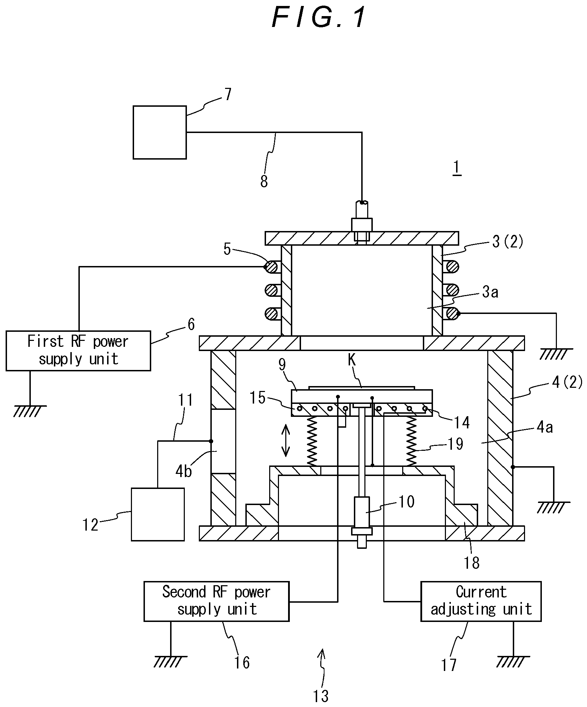

0031 Hereinafter, a specific embodiment of the present invention will be described based on the drawings. Fig. 1 is an illustration showing a schematic configuration of a plasma processing apparatus according to the embodiment.

0032 As shown in Fig. 1, the plasma processing apparatus 1 of this embodiment includes a processing chamber 2, a coil 5, a first RF power supply unit 6, a processing gas supply unit 7, a platen 9, a lifting mechanism 10, an exhaust device 12, and a heating device 13.

0033 The processing chamber 2 is composed of an upper chamber 3 having a plasma generating space 3a, and a lower chamber 4 provided below the upper chamber 3 and having a processing space 4a communicating with the plasma generating space 3a; the platen 9 is disposed in the processing space 4a of the lower chamber 4. Note that the lower chamber 4 is grounded. Further, the plasma generating space 3a and the processing space 4 form a processing portion.

0034 The processing gas supply unit 7 supplies a processing gas into the plasma generating space 3a of the upper chamber 3 through a supply pipe 8 connected to the plasma generating space 3a. The kind of the processing gas is determined in accordance with the processing to be performed on a substrate. There is no restriction on the kind of the processing gas; however, one or more kinds of processing gases are determined, and in the case where two or more kinds of processing gases are supplied, the supply pipe 8 is disposed for each of the processing gases and the processing gases are supplied into the plasma generating space 3a through their respective supply pipes 8.

0035 The coil 5 is wound outside the upper chamber 3; in this embodiment, the coil 5 is wound to have three turns and has one end connected to the first RF power supply unit 6 and the other end grounded. Note that the first RF power supply unit 6 is also grounded. Accordingly, when RF power is supplied to the coil 5 from the first RF power supply unit 6, an induced electric field is produced in the plasma generating space 3a and plasma is generated from a processing gas supplied into the plasma generating space 3a by the induced electric field. The RF power supplied to the coil 5 from the first RF power supply unit 6 typically has the frequency of 13.56 MHz; however, the frequency is not limited thereto. The number of turns of the coil 5 is also not limited to three.

0036 Further, the lifting mechanism 10 is connected to the platen 9 to move up and down the platen 9, and is composed of a cylinder and other components and held by a base member 18 disposed in the processing space 4a. Further, the exhaust device 12 is composed of a vacuum pump and other components and exhausts gas in the processing chamber 2 through an exhaust port 4c formed on the lower chamber 4 and an exhaust pipe 11 connected to the exhaust port 4, thereby bringing the plasma generating space 3a and the processing space 4a into a vacuum state.

0037 The heating device 13 is composed of a holding body 15 having insulation properties and fixed on the lower surface of the platen 9, a heating element 14 formed in a spiral shape and embedded in the holding body 15, a second RF power supply unit 16 connected to the platen 9 and one end of the heating element 14, and a current adjusting unit 17 connected to the other end of the heating element 14.

0038 The second RF power supply unit 16 is grounded and supplies RF power having a frequency equal to or greater than 100 kHz to the platen and the heating element 14. The platen 9 is grounded via the base member 18 and the lower chamber 4, and a circuit including the second RF power supply unit 16 and the platen 9 and a circuit including the second RF power supply unit 16, the heating element 14, and the current adjusting unit 17 are formed in parallel. Further, the current adjusting unit 17 is composed of an amplifier unit and other components and a current flowing to the heating element 14 can be adjusted by adjusting a control signal for the amplifier unit.

0039 The heating element 14 is composed of a conductor having a product $\rho \cdot \mu$ [$\Omega \cdot$H] of its electrical resistivity $\rho$ [$\Omega \cdot$m] and its magnetic permeability $\mu$ [H/m] equal to or greater than $8.0 \times 10^{-13}$; examples of the conductor include ferromagnetic substances such as iron, cobalt, nickel, gadolinium, stainless steel, Fe-Co, Fe-Ni, Fe-Co-Ni, Co-Ni, Fe-Si, Fe-Mn-Zn, Fe-Ni-Zn, Fe-Co-Ni-Cr, Fe-Co-Ni-P, Fe-Co-B, Fe-Co-Cr-B, and Fe-Co-V, nichrome, and alloys made of one or more of the foregoing substances and lanthanide. Further, the heating element 14 may be made by coating an appropriate base material with any one of these conductors, and in the case of this coating mode, it is preferred that the thickness of the coating is equal to or greater than a skin thickness in the skin effect which develops in the case where an RF power having an appropriate frequency is applied.

0040 Further, examples of an insulator forming the holding body 15 include ceramics such as magnesia, alumina, zirconia, and mica, and resin such as polyimide and silicon. Note that reference numeral 19 in Fig. 1 denotes a bellows seal.

0041 According to the plasma processing apparatus 1 having the above-described configuration, first, a substrate K is placed on the platen 9 and the interior of the processing chamber 2 is brought into a vacuum state by the exhaust device 12, and RF power is supplied to the platen 9 and the heating element 14 from the second RF power supply unit 16 in a state where the platen 9 has been appropriately moved upward by the lifting mechanism 10. The heating element 14 generates heat when being supplied with RF power, and the heat energy heats the substrate K through the holding body 15 and the platen 9. Note that the current flowing to the heating element 14 is adjusted by the current adjusting unit 17 so that the substrate K is heated to a target temperature in a desired time period. In this way, the substrate K is preheated.

0042 Subsequently, an appropriate processing gas is supplied into the plasma generating space 3a from the processing gas supply unit 7 and RF power is supplied to the coil 5 from the first RF power supply unit 6, whereby plasma is generated from the processing gas supplied into the plasma generating space 3a. Thus, the substrate K is appropriately processed by the plasma generated from the processing gas. Note that, in this process, a bias potential is applied to the platen 9 due to the generation of plasma, and therefore the substrate K is processed also by ions in the plasma attracted to the substrate K due to the bias potential.

0043 After the substrate K is processed, the plasma processing apparatus 1 is returned to an initial state.

0044 As described above, in the case where RF power is used as a power supply for heating, a smaller current suffices for obtaining the same workload, that is, the same Joule heat, as compared with direct-current power or alternating-current power. Further, using a conductor showing the $\rho \cdot \mu$ [$\Omega \cdot$H] equal to or greater than $8.0 \times 10^{-13}$ in the heating element 14 makes it possible to obtain the same Joule heat with a smaller current as compared with the conventional art. Furthermore, such a conductor shows a great resistance value to RF power; therefore, a small-sized conductor suffices for obtaining the same resistance value.

0045 The heating device 13 of this embodiment makes it possible to miniaturize the heating element 14 since the conductor as described above is used as the heating element 14 and RF power is applied to the heating element 14 from the second RF power supply unit 16. Further, it is possible to heat a substrate K to a target temperature with a small current; therefore, the substrate K can be heated efficiently in terms of energy efficiency.

0046 Further, in the case where this plasma processing apparatus 1 is applied to a small-sized apparatus which processes a substrate K having a diameter equal to or smaller than 1 inch, the heating element 14 can be preferably applied to the platen 9 which is miniaturized corresponding to the substrate K since the size of the heating element 14 can be reduced.

0047 Further, since the current supplied to the heating element 14 is adjusted by the current adjusting unit 17, an amount of heat generation of the heating element 14, that is, a heating temperature of the heating element 14 can be adjusted to an appropriate temperature.

0048 Further, in this embodiment, the second RF power supply unit 16 is shared as an RF power supply for applying a bias potential to the platen 9 and a power supply for heating the platen 9; therefore, the number of power supplies can be reduced as compared with the conventional art that requires an RF power supply for bias potential and an alternating-current or direct-current power supply for heating which are provided separately from each other. Consequently, cost for the plasma processing apparatus 1 can be reduced.

0049 Note that, as described above, the resistance value [$\Omega$] of the heating element 14 in the case where RF power is supplied is proportional to the length of the heating element 14 and the frequency of the RF power. Therefore, as the frequency of the supplied RF power becomes greater, the length of the heating element 14 can be reduced, in other words, the heating element 14 can be miniaturized. In view of this, the frequency of the RF power supplied by the second RF power supply unit 16 is preferred to be equal to or greater than 100 kHz as described above, more preferred to be equal to or greater than 300 kHz, and even more preferred to be equal to or greater than 10 MHz.

0050 Thus, one embodiment of the present invention has been described above; however, the present invention is not limited thereto and can be implemented in other modes.

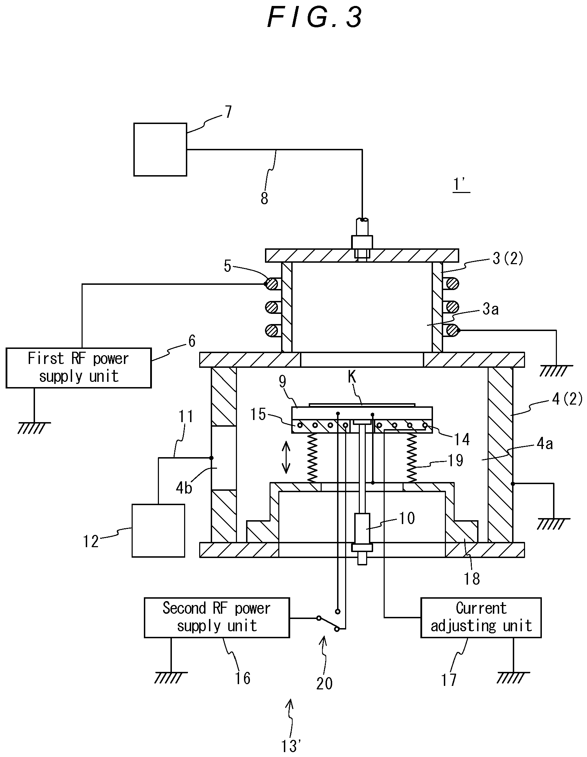

0051 For example, the present invention can be implemented as a plasma processing apparatus 1' shown in Fig. 3. Note that, on the plasma processing apparatus 1', the same components as those of the plasma processing apparatus 1 of the foregoing embodiment are denoted by the same reference numerals.

0052 The plasma processing apparatus 1' has a configuration in which a selector switch 20 is provided on a heating device 13' and the second RF power supply unit 16 is connected to the platen 9 and the heating element 14 via the selector switch 20, and the second RF power supply unit 16 is alternatively connected to the platen 9 or the heating element 14 by switching the selector switch 20, thereby alternatively supplying RF power to the platen 9 or the heating element 14. Heating of the platen 9 is mainly performed at the time of preheating of the substrate K before start of processing so as to start a stable processing immediately after start of processing. Therefore, it is sufficient for the heating element 14 to be supplied with RF power at the time of preheating before start of processing, while it is sufficient for the platen 9 to be supplied with RF power during processing in order to apply a bias potential thereto. Accordingly, the provision of the selector switch 20 enables supplying RF power to the heating element 14 at the time of preheating before start of processing and to the platen during processing by switching the selector switch 20. This configuration can prevent excessive power consumption, and therefore is preferable in terms of energy efficiency.

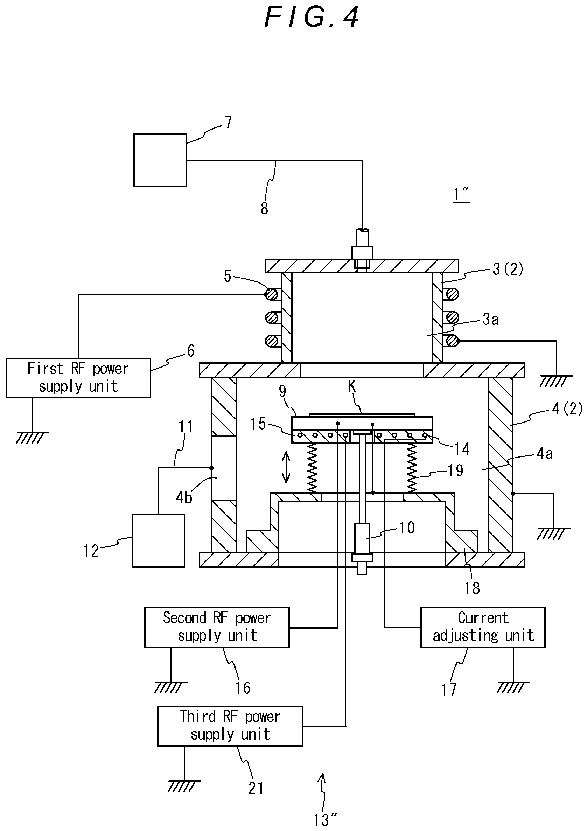

0053 Further, the present invention may be implemented as a plasma processing apparatus 1" shown in Fig. 4. Note that, also on the plasma processing apparatus 1", the same components as those of the plasma processing apparatus 1 of the foregoing embodiment are denoted by the same reference numerals.

0054 The plasma processing apparatus 1" includes a heating device 13" having an RF power supply supplying RF power to the platen 9 and an RF power supply supplying RF power to the heating element 14 which are provided separately from each other; RF power is supplied to the platen 9 from the second power supply 16 and RF power is supplied to the heating element 14 from a third RF power supply unit 21.

0055 Further, although the heating element 14 is embedded in the holding body 15 and the holding body 15 is attached to the lower surface of the platen 9 in the foregoing embodiments, the present invention is not limited thereto and the holding body 15 including the heating element 14 may be embedded in the platen. Further, instead of the configuration in which the heating element 14 is embedded in the holding body 15, a configuration may be employed in which the heating element 14 is covered with an insulator and the covered heating element 14 is attached to the lower surface of the platen 9 or embedded in the platen 9.

0056 Further, although the plasma generating apparatuses 1, 1', 1" of the foregoing embodiments are a so-called inductively coupled plasma (ICP) processing apparatus including the coil 5, the present invention is not limited thereto and may be embodied as any type of plasma processing apparatus using RF power, such as a so-called capacitively coupled plasma (CCP) processing apparatus including parallel plate electrodes.

0057 Further, there is no restriction on the substrate K to be processed, and examples of the substrate K include substrates made of silicon, silicon carbide, sapphire, compound semiconductor, glass, and resin.

0058 Further, although the heating device 13 is applied to the plasma processing apparatuses 1, 1', 1", the present invention is not limited thereto. The heating device 13 may be used alone and may be applied to other types of apparatus.

Reference Signs List

0059

1     Plasma processing apparatus
2     Processing chamber
3     Upper chamber
4     Lower chamber
5     Coil
6     First RF power supply
7     Processing gas supply unit
9     Platen
13    Heating device

14    Heating element
15    Holding body
16    Second RF power supply
17    Current adjusting unit

**Claims**

1.  A heating device, **characterized in that** it comprises a heating element and a heating RF power supply supplying RF power to the heating element, the heating element including a conductor having a product $\rho \cdot \mu$ [$\Omega \cdot$H] of its electrical resistivity $\rho$ [$\Omega \cdot$m] and its magnetic permeability $\mu$ [H/m] equal to or greater than $8.0 \times 10^{-13}$.

2.  The heating device according to claim 1, **characterized in that** the RF power has a frequency equal to or greater than 100 kHz.

3.  The heating device according to claim 1, **characterized in that** the RF power has a frequency equal to or greater than 300 kHz.

4.  The heating device according to claim 1, **characterized in that** the RF power has a frequency equal to or greater than 10 MHz.

5.  The heating device according to any one of claims 1 to 4, **characterized in that** it further comprises a current adjusting unit adjusting a current supplied to the heating element from the heating RF power supply.

6.  The heating device according to any one of claims 1 to 5, **characterized in that** the conductor included in the heating element is selected from iron, cobalt, nickel, nichrome, gadolinium, stainless steel, Fe-Co, Fe-Ni, Fe-Co-Ni, Co-Ni, Fe-Si, Fe-Mn-Zn, Fe-Ni-Zn, Fe-Co-Ni-Cr, Fe-Co-Ni-P, Fe-Co-B, Fe-Co-Cr-B, Fe-Co-V, and alloys made of one or more of them and lanthanide.

7.  A plasma processing apparatus comprising a processing chamber having a processing portion therein, a platen disposed in the processing potion for placing an object to be processed thereon, a processing gas supply unit supplying a processing gas into the processing portion, a plasma generating unit generating plasma from the processing gas supplied into the processing portion by RF power, and a plasma-generation RF power supply supplying RF power to the plasma generating unit, **characterized in that**
    the plasma processing apparatus further comprises the heating device according to any one of claims 1 to 6, and the heating element is attached to or embedded in the platen in a state of being covered with or embedded in an insulator.

8.  The plasma processing apparatus according to claim 7, **characterized in that** the heating RF power supply is connected to the platen and the heating element and is configured to supply RF power to the platen and the heating element.

9.  The plasma processing apparatus according to claim 7, **characterized in that** the heating RF power supply is connected to the platen and the heating element via a connection switching unit and is configured to be alternatively connected to the platen or the heating element by a switching operation in the connection switching unit to alternatively supply RF power to the platen or the heating element.

# F I G . 1

First RF power supply unit

Second RF power supply unit

Current adjusting unit

*FIG. 2*

| Material | $\rho$ [$\Omega \cdot$m] | $\mu$ [H/m] | $\rho \cdot \mu$ [$\Omega \cdot$H] | Resistance value in RF application $\times 10^{-3}$ [$\Omega$] | Resistance value in DC application $\times 10^{-3}$ [$\Omega$] | Resistance value in AC application $\times 10^{-3}$ [$\Omega$] | current in RF application [A] | current in DC application [A] | current in AC application [A] |
|---|---|---|---|---|---|---|---|---|---|
| pure iron | $8.90 \times 10^{-8}$ | $2.51 \times 10^{-1}$ | $2.24 \times 10^{-8}$ | 1550 | 0.019 | 3.27 | 4.4 | 1260.3 | 95.8 |
| permalloy | $5.50 \times 10^{-7}$ | $1.26 \times 10^{-1}$ | $6.91 \times 10^{-8}$ | 2730 | 0.117 | 5.74 | 3.3 | 507.0 | 72.3 |
| steel | $1.00 \times 10^{-7}$ | $6.28 \times 10^{-3}$ | $6.28 \times 10^{-10}$ | 260 | 0.021 | 0.548 | 10.7 | 1189.0 | 234.0 |
| nickel | $6.20 \times 10^{-8}$ | $7.54 \times 10^{-4}$ | $4.67 \times 10^{-11}$ | 71 | 0.013 | 0.149 | 20.6 | 1510.0 | 448.1 |
| nichrome | $1.07 \times 10^{-6}$ | $1.26 \times 10^{-6}$ | $1.35 \times 10^{-12}$ | 12 | 0.228 | 0.228 | 49.9 | 363.0 | 363.0 |
| SUS304 | $7.20 \times 10^{-7}$ | $1.26 \times 10^{-6}$ | $9.05 \times 10^{-13}$ | 9.9 | 0.153 | 0.153 | 55.1 | 443.1 | 443.1 |
| lead | $1.92 \times 10^{-7}$ | $1.26 \times 10^{-6}$ | $2.41 \times 10^{-13}$ | 5.1 | 0.041 | 0.011 | 76.7 | 858.1 | 1671.9 |
| aluminum | $2.50 \times 10^{-8}$ | $1.26 \times 10^{-6}$ | $3.14 \times 10^{-14}$ | 1.8 | 0.005 | 0.004 | 127.6 | 2378.0 | 2783.1 |
| copper | $1.55 \times 10^{-8}$ | $1.26 \times 10^{-6}$ | $1.95 \times 10^{-14}$ | 1.5 | 0.003 | 0.003 | 143.9 | 3020.1 | 3136.5 |
| silver | $1.47 \times 10^{-8}$ | $1.26 \times 10^{-6}$ | $1.85 \times 10^{-14}$ | 1.4 | 0.003 | 0.003 | 145.8 | 3101.1 | 3178.3 |

# FIG. 3

# F I G . 4

First RF power supply unit — 6

Second RF power supply unit — 16

Third RF power supply unit — 21

Current adjusting unit — 17

## INTERNATIONAL SEARCH REPORT

| International application No. |
| --- |
| PCT/JP2014/059435 |

**A. CLASSIFICATION OF SUBJECT MATTER**
*H01L21/02*(2006.01)i, *H01L21/3065*(2006.01)i, *H05B3/68*(2006.01)i

According to International Patent Classification (IPC) or to both national classification and IPC

**B. FIELDS SEARCHED**

Minimum documentation searched (classification system followed by classification symbols)
H01L21/02, H01L21/3065, H05B3/68

Documentation searched other than minimum documentation to the extent that such documents are included in the fields searched
Jitsuyo Shinan Koho        1922–1996   Jitsuyo Shinan Toroku Koho   1996–2014
Kokai Jitsuyo Shinan Koho   1971–2014   Toroku Jitsuyo Shinan Koho   1994–2014

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>A | JP 2005-191056 A  (Tokyo Electron Ltd.),<br>14 July 2005 (14.07.2005),<br>paragraphs [0021] to [0046]; fig. 1 to 2<br>& US 2005/0236111 A1 | 1-7<br>8-9 |
| A | JP 10-256243 A  (Matsushita Electric Industrial Co., Ltd.),<br>25 September 1998 (25.09.1998),<br>entire text; fig. 1<br>(Family: none) | 1-9 |
| A | JP 2008-153194 A  (NGK Insulators, Ltd.),<br>03 July 2008 (03.07.2008),<br>paragraphs [0011] to [0042]; fig. 1<br>& US 2008/0142501 A1    & KR 10-2008-0056085 A<br>& CN 101207945 A | 1-9 |

☐ Further documents are listed in the continuation of Box C.      ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>23 May, 2014 (23.05.14) | Date of mailing of the international search report<br>10 June, 2014 (10.06.14) |
| --- | --- |
| Name and mailing address of the ISA/<br>Japanese Patent Office | Authorized officer |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H10303185 B